(19) Europäisches Patentamt / European Patent Office / Office européen des brevets

(11) **EP 2 610 058 A1**

(12) **EUROPEAN PATENT APPLICATION**
published in accordance with Art. 153(4) EPC

(43) Date of publication:
**03.07.2013 Bulletin 2013/27**

(21) Application number: **12797470.7**

(22) Date of filing: **24.04.2012**

(51) Int Cl.:
**B32B 27/00** (2006.01)    **B32B 3/14** (2006.01)
**H01L 33/50** (2010.01)

(86) International application number:
**PCT/JP2012/060912**

(87) International publication number:
**WO 2012/169289** (13.12.2012 Gazette 2012/50)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.06.2011    JP 2011126934**

(71) Applicant: **Toray Industries, Inc.**
**Tokyo 103-8666 (JP)**

(72) Inventors:
• **MATSUMURA, Nobuo**
  **Shiga 520-8558 (JP)**
• **ISHIDA, Yutaka**
  **Shiga 520-8558 (JP)**

• **KAWAMOTO, Kazunari**
  **Shiga 520-8558 (JP)**
• **INOUE, Takejiro**
  **Shiga 520-8558 (JP)**
• **SADAKUNI, Hironobu**
  **Shiga 520-8558 (JP)**
• **YOSHIOKA, Masahiro**
  **Shiga 520-8558 (JP)**
• **KITAGAWA, Takao**
  **Shiga 520-8558 (JP)**

(74) Representative: **Hoefer & Partner**
**Pilgersheimer Straße 20**
**81543 München (DE)**

(54) **RESIN SHEET LAMINATED BODY, METHOD FOR PRODUCING SAME, AND METHOD FOR PRODUCING LED CHIP WITH PHOSPHOR-CONTAINING RESIN SHEET USING SAME**

(57)    In order to improve the color and luminance uniformity of an LED chip with a phosphor-containing resin sheet obtained by adhering the phosphor-containing resin sheet to the LED chip, improve the ease of production, and improve the degree of freedom in design, etc., provided is a resin sheet laminate provided with a phosphor-containing resin sheet on a base material, wherein the phosphor-containing resin sheet is divided into a plurality of sections.

**Fig. 2**

**Description**

TECHNICAL FIELD

The present invention relates to a resin sheet laminate provided with a resin sheet containing a phosphor on a base material. More particularly, the present invention relates to a resin sheet laminate having many sheet-like phosphor materials for converting an emission wavelength of an LED chip, arrayed on a substrate.

BACKGROUND ART

A light emitting diode is rapidly expanding its market for a backlight of a liquid crystal display (LCD) and for general lighting in addition to lighting in automotive applications such as headlight because of a low power consumption, a long life time and design against the background of significant improvement in luminance efficiency.

An emission color of an LED is limited since an emission spectrum of the LED depends on a semiconductor material for forming the LED chip. Therefore, in order to obtain LCD backlight or white light for general lighting by using an LED, it is necessary that a phosphor suitable for an LED chip is arranged on the LED chip to convert an emission wavelength. Specifically, a method of disposing a yellow phosphor on an LED chip to emit blue light, a method of disposing a red phosphor and a green phosphor on an LED chip to emit blue light, and a method of disposing a red phosphor, a green phosphor and a blue phosphor on an LED chip to emit ultraviolet light are proposed. Among these methods, the method of disposing a yellow phosphor on an LED chip to emit blue light, and the method of disposing a red phosphor and a green phosphor on an LED chip to emit blue light are currently most widely employed from luminance efficiency and cost standpoints of the LED chip.

Patent Documents 1 to 2 propose a method of dispersing a phosphor in a liquid resin for sealing an LED chip as a specific method of disposing a phosphor on the LED chip. However, when dispersion of the phosphor in the liquid resin is nonuniform, color irregularities arise among LED chips. Further, since a regular quantity is hardly maintained when supplying a liquid resin on an LED chip separately and thickness variation of the resin is easily produced during curing the liquid resin, it is difficult to maintain the amount of the phosphor arranged on the LED chip constantly.

Thus, a method of using a sheet-like resin layer in which a fluorescent material is uniformly distributed in advance is proposed (for example, Patent Documents 3 and 4). A phosphor to be arranged on each LED chip can be constant and quality of the LED can be improved by forming a material in which a fluorescent material is uniformly dispersed in advance into a sheet having a uniform thickness by coating, cutting the resulting sheet into a small piece, and bonding it to an LED chip.

PRIOR ART DOCUMENTS

PATENT DOCUMENTS

PATENT DOCUMENT 1: Japanese Patent Laid-open Publication No. 5-152609
PATENT DOCUMENT 2: Japanese Patent Laid-open Publication No. 7-99345
PATENT DOCUMENT 3: Japanese Patent Publication No. 4146406
PATENT DOCUMENT 4: Japanese Patent Laid-open Publication No. 2000-156528

SUMMARY OF THE INVENTION

PROBLEMS TO BE SOLVED BY THE INVENTION

It is necessary to supply LEDs having small color irregularities of emission color stably for widely adapting the LEDs to general lighting uses in place of incandescent bulbs or fluorescent lamps. As described above, the method in which a fluorescent material is uniformly dispersed in a resin in advance and the resin is formed into a sheet having a uniform thickness is excellent as a method of suppressing color irregularities, but this method has a problem that a step of cutting a sheet and a step of bonding the sheet to an LED chip by use of an adhesive are added to a manufacturing process of a light emitting device using the LED to make the manufacturing process complicated and expensive.

When the phosphor-containing resin is formed into a sheet in advance, the sheet has to be disposed on a separate LED chip. For example, when the phosphor-containing resin sheet has been cut into a size for disposing on a separate LED chip in advance, it is difficult to handle a phosphor-containing sheet cut into a singulated piece of about 1 mm. Further, the work of bonding the singulated pieces to the LED chip one by one by using an adhesive requires accuracy, and it is difficult to achieve a manufacturing speed and accuracy simultaneously.

As an alternative method, there is a method in which the phosphor-containing resin sheet is bonded to the LED as in the form of a continuous sheet without cutting into singulated pieces. In this case, there are two cases, the case where singulated LED chip is bonded to a sheet-like phosphor-containing resin sheet and the case where the LED is collectively bonded to the phosphor-containing resin sheet as in the form of a wafer before separating into singulated pieces. However, in any method, a method of cutting the phosphor-containing resin sheet after bonding it to the LED chip is limited. Particularly, in the latter case, it is difficult to cut the phosphor-containing resin sheet concurrently with cutting of a wafer of the LED. Further, when the phosphor-containing resin sheet is cut after bonding it to the LED chip, a cutting configuration is limited to a configuration following a configuration of the LED chip or a larger configuration than that of the LED chip. Accordingly, when it is desired to cover a part of the surface of the LED chip with the phosphor-containing resin sheet and expose another part of the surface, for example, for the case of forming a lead out of an electrode on the surface of the LED chip, it is difficult to eliminate only the part of the phosphor-containing resin sheet, corresponding to the another part.

The present inventors made earnest investigations concerning the characteristics of uniformity in color and luminance, ease of manufacturing and design flexibility of an LED chip with a phosphor-containing resin sheet having a phosphor-containing resin sheet bonded thereto, and consequently the present inventors found that in order to improve all these characteristics, a machining method and a configuration of the phosphor-containing resin sheet are very important.

SOLUTIONS TO THE PROBLEMS

The present invention enables to enhance the productivity of an LED chip with a phosphor-containing resin sheet while improving the uniformity of luminance and color of an LED, a color of which is converted by a phosphor, by previously providing a predetermined configuration for the phosphor-containing resin sheet, and specifically, the present invention is characterized by any of the following constitutions.

(1) A resin sheet laminate provided with a phosphor-containing resin sheet on a base material, wherein the phosphor-containing resin sheet is divided into a plurality of sections.

(2) The resin sheet laminate according to the above-mentioned paragraph (1), wherein the base material is continuous in-plane direction throughout the plurality of sections of the phosphor-containing resin sheet.

(3) The resin sheet laminate according to the above-mentioned paragraph (1) or (2), wherein the base material has a concave portion at the same position as the position of a boundary dividing a phosphor-containing resin sheet.

(4) The resin sheet laminate according to any one of the above-mentioned paragraphs (1) to (3), wherein a release agent is present between the base material and the phosphor-containing resin sheet.

(5) The resin sheet laminate according to any one of the above-mentioned paragraphs (1) to (3), wherein an adhesive layer is laminated on the phosphor-containing resin sheet.

(6) The resin sheet laminate according to any one of the above-mentioned paragraphs (1) to (5), wherein the base material having the phosphor-containing resin sheet laminated thereon is a resin film.

(7) The resin sheet laminate according to any one of the above-mentioned paragraphs (1) to (6), wherein in the sections in the phosphor-containing resin sheet, its configuration at the time when viewed from a direction perpendicular to in-plane direction of the sheet is a regularly repeated pattern.

(8) The resin sheet laminate according to any one of the above-mentioned paragraphs (1) to (7), wherein the phosphor-containing resin sheet is bonded to an emission surface of an LED.

(9) A method for manufacturing the resin sheet laminate according to any one of the above-mentioned paragraphs (1) to (8), which forms a phosphor-containing resin sheet divided into a plurality of sections on a base material to manufacture a resin sheet laminate, wherein a step of dividing the phosphor-containing resin sheet into a plurality of sections is performed by at least one method among etching by chemicals, patterning by screen printing, punching by a die, machining by a laser beam and cutting by a blade.

(10) A method for manufacturing an LED chip with a phosphor-containing resin sheet, comprising the steps of: (A) bonding an emission surface of the LED chip to the divided phosphor-containing resin sheet in the resin sheet laminate according to any one of the above paragraphs (1) to (8), and (B) peeling the phosphor-containing resin sheet bonded to the emission surface of the LED chip from the base material.

(11) The method for manufacturing an LED chip with a phosphor-containing resin sheet according to the above paragraph (10), wherein in the step (A), the emission surfaces of a plurality of LED chips arranged so as to correspond to an arrangement of a plurality of sections of the phosphor-containing resin sheet are collectively bonded to the phosphor-containing resin sheet.

EFFECTS OF THE INVENTION

In accordance with the present invention, the LED chip with a phosphor-containing resin sheet having uniform luminance and color can be manufactured by an easy process.

BRIEF DESCRIPTION OF THE DRAWINGS

Fig. 1 is a view showing a first example of a constituent sectional view of a resin sheet laminate of the present invention.
Fig. 2 is a view showing a second example of the constituent sectional view of the resin sheet laminate of the present invention.
Fig. 3 is a view showing a third example of the constituent sectional view of the resin sheet laminate of the present invention.
Fig. 4 is a view showing a fourth example of the constituent sectional view of the resin sheet laminate of the present invention.
Fig. 5 is a view showing a first example of plane view of the resin sheet laminate of the present invention.
Fig. 6 is a view showing a second example of the plane view of the resin sheet laminate of the present invention.
Fig. 7 is a view showing a third example of the plane view of the resin sheet laminate of the present invention.
Fig. 8 is a view showing a fourth example of the plane view of the resin sheet laminate of the present invention.
Fig. 9 is a view showing a fifth example of the plane view of the resin sheet laminate of the present invention.
Fig. 10 is a view showing a sixth example of the plane view of the resin sheet laminate of the present invention.
Fig. 11 is a view showing a first example of a process for preparing a resin sheet laminate of the present invention.
Fig. 12 is a view showing a second example of the process for preparing a resin sheet laminate of the present invention.
Fig. 13 is a view showing a third example of the process for preparing a resin sheet laminate of the present invention.
Fig. 14 is a view showing a first example of a method for mounting a phosphor-containing resin sheet in the resin sheet laminate of the present invention on an LED chip.
Fig. 15 is a view showing a second example of the method for mounting the phosphor-containing resin sheet in the resin sheet laminate of the present invention on an LED chip.
Fig. 16 is a view showing a third example of the method for mounting the phosphor-containing resin sheet in the resin sheet laminate of the present invention on an LED chip.
Fig. 17 is a view showing a fourth example of the method for mounting the phosphor-containing resin sheet in the resin sheet laminate of the present invention on an LED chip.

EMBODIMENTS OF THE INVENTION

(Basic Constitution of Resin Sheet Laminate)

A resin sheet laminate of the present invention is a resin sheet laminate provided with a phosphor-containing resin sheet on a base material, in which the phosphor-containing resin sheet is divided into a plurality of sections. The phosphor-containing resin sheet can be divided into the desired number of sections with a desired shape and dimension according to its objective. On the other hand, the base material for supporting the phosphor-containing resin sheet is monolithic (continuous in-plane direction) throughout a plurality of sections of the phosphor-containing resin sheet, and the phosphor-containing resin sheet is not fragmented separately.

In the resin sheet laminate of the present invention, a phosphor resin layer having a uniform thickness and uniform composition can be formed on each LED since a resin sheet in which the phosphor is uniformly dispersed is formed in advance. Further, while the resin sheet is divided into a desired shape in advance, these divided resin sheets are combined by the base material, and therefore the resin sheet can be easily bonded to the LED chip. Accordingly, an LED which is uniform in luminance and color can be manufactured by an easy process by using the resin sheet laminate of the present invention.

Thus, the base material in the resin sheet laminate of the present invention is preferably undivided. Here, in the present specification, a phrase "the base material is undivided" refers to a state in which the base material is not fully separated. That is, this state includes not only the case where a cut is not made in the base material, but also the case where the base material has partially a cut not penetrating the base material and the case where the base material has partially a break penetrating the base material but the base material retains a monolithic configuration as a whole.

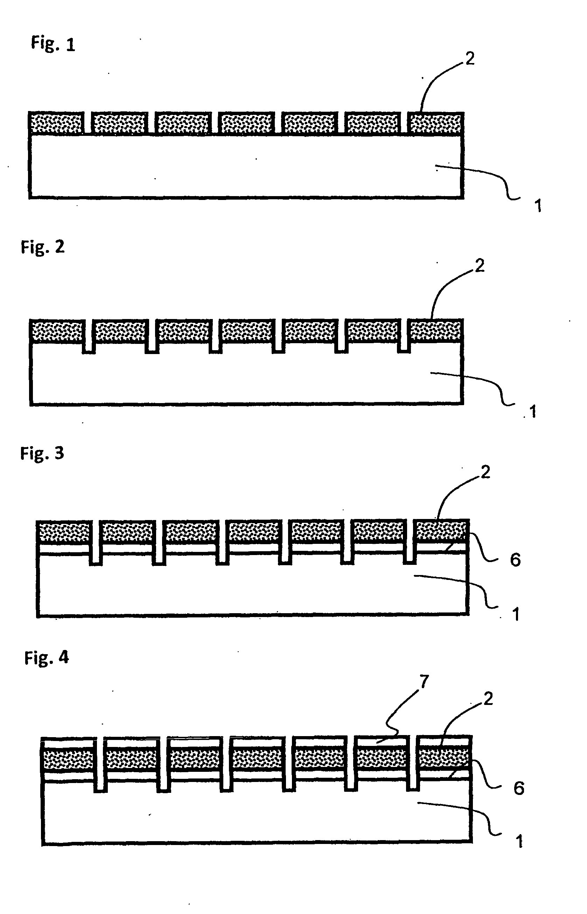

The constitution of the resin sheet laminate of the present invention will be described by a sectional view by use of Figs 1 to 4. In addition, these are examples, the resin sheet laminate of the present invention is not limited to these examples.

Fig. 1 is a view showing an example of a constitution of the resin sheet laminate of the present invention. A phosphor-containing resin sheet 2 divided into a predetermined configuration is laminated on an undivided base material 1.

Fig. 2 is a view showing a second example of a constitution of the resin sheet laminate of the present invention. A phosphor-containing resin sheet 2 divided into a predetermined configuration is laminated on a base material 1, and the base material 1 has a concave portion at the same position as that of a boundary dividing a phosphor-containing resin layer. In addition, "the same position" referred to herein refers to a position where the concave portion of the base material is in agreement with the boundary of the phosphor- containing resin layer with accuracy of plus or minus 10 $\mu$m. In this time, a part of the concave portion of the base material may be a break penetrating the base material as long as the base material is monolithic, and this is also common to constitutions in Fig. 3 and Fig. 4 described later. When the resin sheet laminate has the constitution described above, it is preferred since an adjacent section is not peeled when only one section of the phosphor-containing resin sheet is peeled off. If the base material does not have such a concave portion in peeling the phosphor-containing resin sheet divided into sections for every section from the base material, there is a fear that an adjacent section is simultaneously peeled off when the section is very small. On the other hand, when the concave portion with depth not penetrating the base material is provided, stress is dispersed and a large peeling force is not exerted on the adjacent section.

Fig. 3 is a view showing a third example of a constitution of the resin sheet laminate of the present invention. A phosphor-containing resin sheet 2 divided into a predetermined configuration is laminated on a base material 1, and the base material 1 has a concave portion at the same position as the position of a boundary dividing a phosphor-containing resin layer. "The same position" referred to herein refers to a position having the same meaning as in the above description. A release agent 6 is present between the base material 1 and the phosphor-containing resin sheet 2. A constitution in which the release agent is present between the base material and the phosphor-containing resin sheet is one of preferable aspects of the present invention, and this facilitates peeling of the base material 1 from the phosphor containing resin sheet 2 when bonding the phosphor-containing resin sheet 2 to an LED chip. The release agent is preferably used when the phosphor-containing resin sheet 2 cannot be easily peeled from the base material 1 although there may be cases where the phosphor-containing resin sheet can be easily peeled from the base material even when the release agent is not present depending on the composition of the phosphor-containing resin sheet 2 and the base material 1.

A constitution in which an adhesive layer is present on at least one of both surfaces of the phosphor-containing resin sheet is one of more preferable aspects of the present invention. The reason for this is that the adhesive power of the phosphor-containing resin sheet to the LED chip can be enhanced by the existence of the adhesive layer when the phosphor-containing resin sheet 2 does not have adhesion or have tackiness which is not enough for bonding to an LED chip.

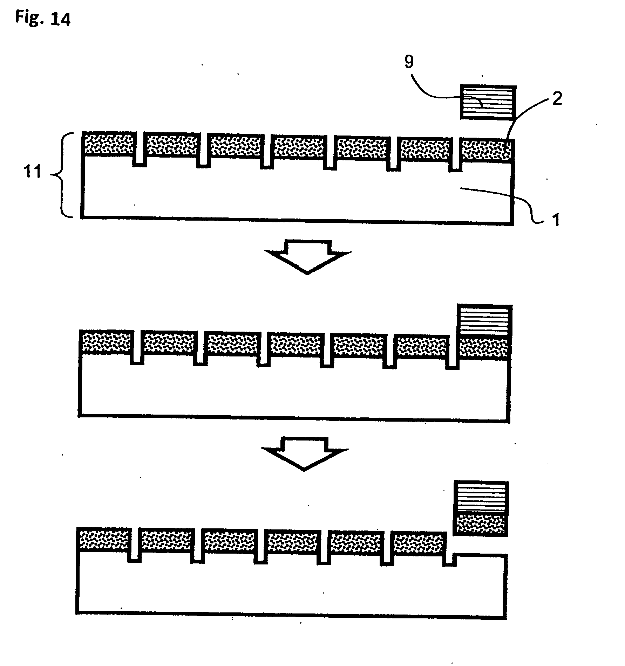

Fig. 4 is a view showing a fourth example of a constitution of the resin sheet laminate of the present invention. A phosphor-containing resin sheet 2 divided into a predetermined configuration is laminated on a base material 1, and the base material 1 has a concave portion at the same position as a position of a boundary dividing a phosphor-containing resin layer. "The same position" referred to herein also refers to a position having the same meaning as in the above description. A release agent 6 is present between the base material 1 and the phosphor-containing resin sheet 2, and further an adhesive layer 7 is present on the phosphor-containing resin sheet 2. The reason for this is that the adhesive power of the phosphor-containing resin sheet to the LED chip can be enhanced when the phosphor-containing resin sheet is bonded to the LED chip before the phosphor-containing resin sheet is peeled from the base material, as with the case described in Fig. 14 described later. In addition, as a variation of Fig. 4, an aspect in which the release agent 6 is not present may be employed.

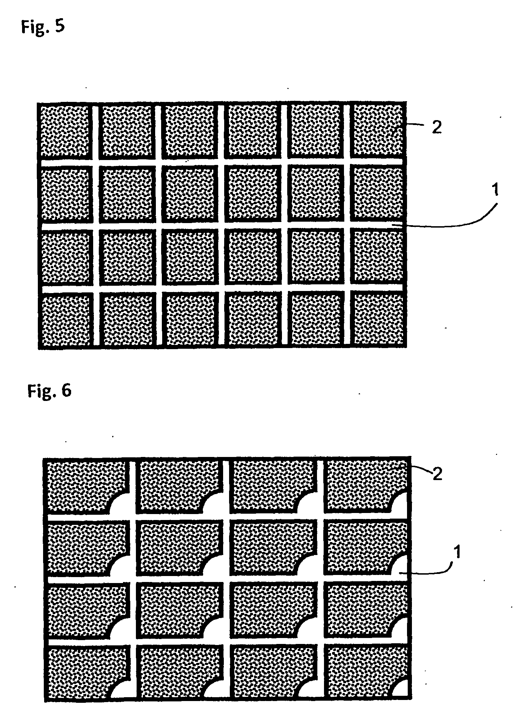

Next, in Fig. 5 to Fig. 10, constitutions of the resin sheet laminates of the present invention will be described by plane view. In addition, the constitutions shown by these plane views can be applied to any of the constitutions described above by a sectional view. Further, these are examples, and the resin sheet laminate of the present invention is not limited to these examples.

Fig. 5 is a view showing an example of a constitution of the present invention, and is plane view of a resin sheet laminate in which the phosphor-containing resin sheet 2 divided into sections is laminated on a monolithic base material 1. The phosphor-containing resin sheet 2 is divided into rectangular sections, and rectangular sections are arrayed in the form of a lattice.

The phosphor-containing resin sheet 2 may be subjected to machining other than dividing into sections. Fig. 6 is a view showing an example of a constitution of the present invention, and is plane view of a resin sheet laminate in which the phosphor-containing resin sheet 2 divided into sections is laminated on a monolithic base material 1, and each section of the phosphor-containing resin sheet 2 is formed into a desired shape by machining a part of each section. When a part of each section of the divided phosphor-containing resin sheet 2 is machined, the machined portion may penetrate the base material.

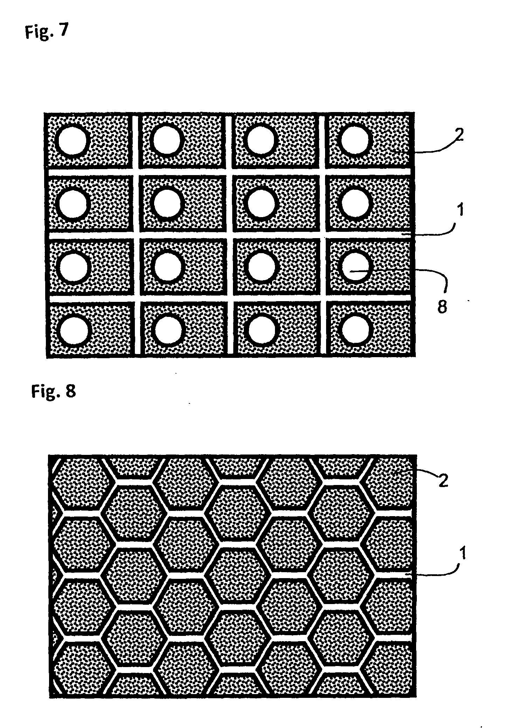

Fig. 7 is a view showing another example of a constitution of the present invention, and is plane view of a resin sheet laminate in which the phosphor-containing resin sheet 2 divided into sections is laminated on a monolithic base material 1, and each section of the phosphor-containing resin sheet 2 is formed into a desired shape by punching a part of each section together with the base material to form a through hole 8.

By forming each section of the phosphor-containing resin sheet 2 into a desired shape by machining a part of each section as shown in Fig. 6 and Fig. 7, it becomes possible to cover the LED chip partially with the phosphor-containing resin sheet and expose the LED chip partially. It is possible to respond to various design freely, for example, design for the case where a wavelength of a part of light emitted from the emission surface of the LED chip is converted through the phosphor-containing resin sheet, and another part of light is taken out as is with no conversion in wavelength, and these two types of light are mixed to adjust an emission color, or design for the case where in order to form a lead out of an electrode at a part of the surface of the LED chip, the part is not covered with the phosphor-containing resin sheet.

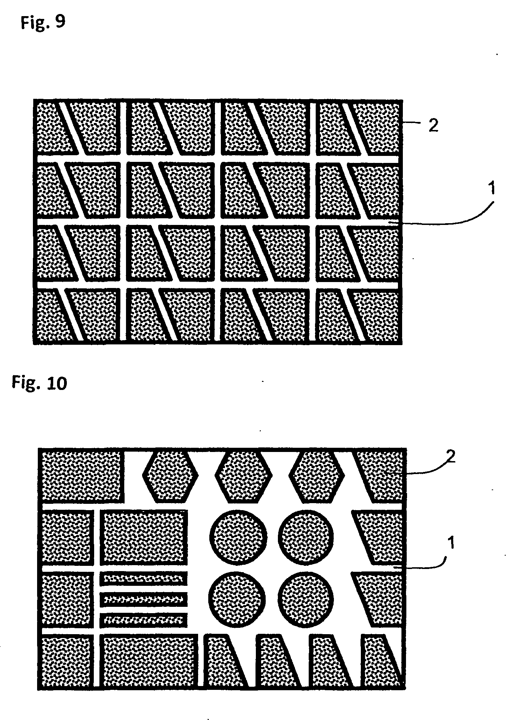

Further, sections of the phosphor-containing resin sheet arrayed on the base material does not have to be rectangular, and the sections may be hexagonal as shown in Fig. 8 or polygonal otherwise, or may be circular or ellipsoidal. In a usual mass production process, since all of the LED elements to which the phosphor-containing resin sheet is bonded have the same configuration, it is preferred that all of sections of the phosphor-containing resin sheet have the same configuration and are arrayed at a constant pitch. However, sections of the phosphor-containing resin sheet arrayed on the base material does not have to have the same configuration depending on the design of the LED element, and as shown in Fig. 9, sections having two types of configurations may be repeatedly arrayed. It is possible to design a configuration freely as required, for example, design in which the emission surface of the LED elements, to which the phosphor-containing resin sheet is bonded, is partitioned into two sections in order to locate an area where the phosphor-containing resin sheet is not bonded partially on the emission surface of the LED element.

In an industrial mass production process, it is preferred that in the sections in the phosphor-containing resin sheet, its configuration at the time when viewed from a direction perpendicular to in-plane direction of the sheet is a regularly repeated pattern. It is one example of the regularly repeated pattern that as shown in Figs. 5 to 8, sections all having the same configuration are arrayed repeatedly, or that as shown in Fig. 9, a combined pattern of sections having two or more different configurations is arrayed repeatedly. In addition, when the configuration/design of the LED element covers a wide variety according to conditions of manufacturing of a wide variety of products in small quantities, as shown in Fig. 10, the phosphor-containing resin sheet on the base material may be machined into sections having a wide variety of configurations.

(Base Material)

As the base material 1, known metal, film, glass, ceramic, paper or the like can be used. Specific examples of the base material include plates or foils of metal such as aluminum (including aluminum alloy), zinc, copper and iron; resin films such as cellulose acetate, polyethylene terephthalate (PET), polyethylene, polyester, polyamide, polyimide, polystyrene, polypropylene, polycarbonate, polyvinyl acetal and aramid; and paper having plastics (polyethylene, polypropylene, polystyrene, etc.) laminated thereon or paper coated with plastics (polyethylene, polypropylene, polystyrene, etc.), paper or films of plastics having the above-mentioned metals laminated thereon or deposited thereon. Among them, as the base material, flexible film-like materials are preferred from the viewpoints of adhesion in bonding a phosphor-containing resin sheet to the LED element, and films having high strength are preferred in order to avoid a fear of breaking in handling a film-like base material. A resin film is preferred from the viewpoints of the above-mentioned required characteristics and economic efficiency, and among resin films, a PET film is particularly preferred. When an elevated temperature of 200°C or more is required in curing a resin, a polyimide film is more preferred from the viewpoints of heat resistance. The base material may be previously subjected to release treatment of a surface for ease of releasing a sheet. Further, when the base material is a metal plate, the plate surface may be subjected to chrome- or nickel-plating or ceramic treatment.

The thickness of the base material is not particularly limited, but a lower limit is preferably 40 $\mu$m or more, and more preferably 60 $\mu$m or more. Also, an upper limit is preferably 5000 $\mu$m or less, and more preferably 3000 $\mu$m or less.

(Phosphor-Containing Resin Sheet)

A component of the phosphor-containing resin sheet 2 is not particularly limited as long as it contains primarily a resin and a phosphor, and various components can be used. Other component may be contained in the component as required.

(Phosphor)

The phosphor absorbs light emitted from the LED chip, converts the wavelength of the light and emits light different in wavelength from the light of the LED chip. Thereby, a part of light emitted from the LED chip is mixed with a part of light emitted from the phosphor to obtain an LED of multiple colors including a white color. Specifically, by optically combining a blue LED with a phosphor which emits light of yellowish emission colors by light from the LED, it is possible to emit white light by using a single LED chip.

The phosphors described above include various phosphors such as a phosphor emitting green light, a phosphor emitting blue light, a phosphor emitting yellow light, a phosphor emitting red light and the like. Specific examples of the phosphor used in the present invention include known phosphors such as inorganic phosphors, organic phosphors, fluorescent pigments and fluorescent dyes. Examples of the organic phosphors include allylsulfoamide-melamineformaldehyde cocondensation dyes and perylene phosphors, and the perylene phosphor is preferably used since it can be used for the long term. The fluorescent material particularly preferably used in the present invention includes inorganic phosphors. Hereinafter, the inorganic phosphor used in the present invention will be described.

Examples of a phosphor emitting green light include $SrAl_2O_4$:Eu, $Y_2SiO_5$:Ce, Tb, $MgAl_{11}O_{19}$:Ce, Tb, $Sr_7Al_{12}O_{25}$: Eu, and (at least one of Mg, Ca, Sr and Ba)$Ga_2S_4$:Eu.

Examples of a phosphor emitting blue light include $Sr_5(PO_4)_3$Cl:Eu, $(SrCaBa)_5(PO_4)_3$Cl:Eu, $(BaCa)_5(PO_4)_3$Cl: Eu, (at least one of Mg, Ca, Sr and Ba)$_2B_5O_9$Cl:Eu, Mn, and (at least one of Mg, Ca, Sr and Ba) $(PO_4)_6Cl_2$:Eu, Mn.

Examples of a phosphor emitting green-yellow light include an yttrium-aluminum oxide phosphor activated with at least cerium, an yttrium-gadolinium-aluminum oxide phosphor activated with at least cerium, yttrium-aluminum-garnet oxide phosphor activated with at least cerium, and an yttrium-gallium-aluminum oxide phosphor activated with at least cerium (the so-called YAG-based phosphor). Specifically, $Ln_3M_5O_{12}$:R (Ln is at least one selected from among Y, Gd and La, M includes at least one of either Al or Ca, and R is a lanthanoid-based phosphor) and $(Y_{1-x}Ga_x)_3(Al_{1-y}Ga_y)_5O_{12}$: R (R is at least one selected from Ce, Tb, Pr, Sm, Eu, Dy and Ho, and 0 < Rx < 0.5, 0 < y < 0.5) can be used.

Examples of a phosphor emitting red light include $Y_2O_2S$:Eu, $La_2O_2S$:Eu, $Y_2O_3$:Eu, and $Gd_2O_2S$:Eu.

Further, examples of a phosphor emitting light compatible with a blue LED which is currently mainstream include YAG-based phosphors such as $Y_3$(Al, Ga)$_5O_{12}$:Ce, (Y, Gd)$_3Al_5O_{12}$:Ce, $Lu_3Al_5O_{12}$:Ce and $Y_3Al_5O_{12}$:Ce; TAG-based phosphors such as $Tb_3Al_5O_{12}$:Ce; silicate-based phosphors such as (Ba, Sr)$_2SiO_4$:Eu phosphor, $Ca_3Sc_2Si_3O_{12}$:Ce phosphor and (Sr, Ba, Mg)$_2SiO_4$:Eu phosphor; nitride-based phosphors such as (Ca, Sr)$_2Si_5N_8$:Eu, (Ca, Sr)AlSiN$_3$:Eu and CaSiAlN$_3$:Eu, oxynitride-based phosphors such as Cax(Si, Al)$_{12}$(O, N)$_{16}$: Eu; and (Ba, Sr, Ca)$Si_2O_2N_2$:Eu phosphor, $Ca_8MgSi_4O_{16}Cl_2$:Eu phosphor, $SrAl_2O_4$:Eu, and $Sr_4Al_{14}O_{25}$:Eu.

Among these phosphors, YAG-based phosphors, TAG-based phosphors and silicate-based phosphors are preferably used from the viewpoints of luminance efficiency and luminance.

Known phosphors other than the above phosphors can be used according to uses or a desired emission color.

A particle size of the phosphor is not particularly limited, but a particle size in which D 50 is 0.05 $\mu$m or more is preferred, and a particle size in which D 50 is 3 $\mu$m or more is more preferred. Further, a particle size in which D 50 is 30 $\mu$m or less is preferred, and a particle size in which D 50 is 20 $\mu$m or less is more preferred. Herein, D 50 refers to a particle diameter at which the cumulative percent passing from the small particle-size side in a volume based particle size distribution obtained by measuring with a laser diffraction/scattering particle size distribution measurement method reaches 50%. When D 50 is within the above-mentioned range, dispersibility of the phosphor in the phosphor sheet is good, and stable emission is achieved.

(Resin)

The resin in the phosphor-containing resin sheet used in the present invention is a resin for containing a phosphor therein, and eventually forms the sheet. Accordingly, any resin may be employed as the resin as long as it allows the phosphor to be uniformly dispersed therein and can form a sheet. Specific examples of the resin include a silicone resin, an epoxy resin, a polyallylate resin, a PET modified polyallylate resin, a polycarbonate resin, cyclic olefin, a polyethylene terephthalate resin, a polymethyl methacrylate resin, a polypropylene resin, modified acryl, a polystyrene resin, and an acrylonitrile-styrene copolymer resin. In the present invention, the silicone resin or the epoxy resin is preferably used from the viewpoints of transparency. Furthermore, the silicone resin is particularly preferably used from the viewpoints of heat resistance.

As such the silicone resin, a curable silicone rubber is preferred. Any liquid form of a one-component liquid form and two-component liquid form (three-component liquid form) may be employed. A type of the curable silicone rubber includes a type in which a condensation reaction occurs by moisture in the air or a catalyst, and this type includes a dealcoholization type, a deoximation type, an acetic acid elimination type, and a hydroxyamine elimination type. A type in which a hydrosilylation reaction occurs by a catalyst includes an addition cure type. Any of these types of curable silicone rubbers may be used. Particularly, the addition cure silicone rubber is more preferred in that a by-product associated with a curing reaction is not produced, shrinkage by curing is small, and curing can be easily accelerated by heating.

The addition cure silicone rubber is formed, as an example, by a hydrosilylation reaction of a compound containing an alkenyl group coupled with a silicon atom and a compound containing a hydrogen atom coupled with a silicon atom. Examples of the resin materials described above include compounds formed by a hydrosilylation reaction of compounds containing an alkenyl group coupled with a silicon atom, such as vinyltrimethoxysilane, vinyltriethoxysilane, allyltrimethoxysilane, propenyltrimethoxysilane, norbornenyltrimethoxysilane and (octenyl)trimethoxysilane and compounds containing a hydrogen atom coupled with a silicon atom, such as methylhydrogenpolysiloxane, dimethylpolysiloxane-CO-methylhydrogenpolysiloxane, ethylhydrogenpolysiloxane and methylhydrogenpolysiloxane-CO-methylphenylpolysiloxane, Further, other materials, for example, known materials described in Japanese Patent Laid-open Publication No. 2010-159411, can be utilized.

Further, as commercialized products, it is also possible to use general-use silicone encapsulation materials for LED. Specific examples of such the encapsulation materials include OE-6630 A/B and OE-6636 A/B manufactured by Dow Corning Toray Co., Ltd. and SCR-1012 A/B and SCR-1016 A/B manufactured by Shin-Etsu Chemical Co., Ltd.

(Other Components)

It is also possible to add a dispersant or a leveling agent for stabilizing a coated film as an additive, or an adhesion aid such as a silane coupling agent as a modifier of a sheet surface to the phosphor-containing sheet. Also, inorganic particles such as silicone particles can be added as an anti-precipitation agent for a phosphor.

The silicone particles for anti-precipitation of the phosphor preferably has an average particle size (D 50) of 0.01 $\mu$m or more and less than 5 $\mu$m. When the average particle size (D 50) is 0.01 $\mu$m or more, the silicone particles can be easily produced and dispersed in the phosphor-containing resin sheet. When the average particle size (D 50) is less than 5 $\mu$m, the transmittance of the phosphor-containing resin sheet is not adversely affected.

(Phosphor Content)

The content of the phosphor is preferably 53% by weight or more, and more preferably 60% by weight or more of the whole phosphor sheet. By adjusting the content of the phosphor in the phosphor-containing resin sheet to the above range, light-resistance of the phosphor-containing resin sheet can be enhanced. In addition, an upper limit of the phosphor content is not particularly limited, but the content is preferably 95% by weight or less, more preferably 90% by weight or less, furthermore preferably 85% by weight or less, and particularly preferably 80% by weight or less of the whole weight of the phosphor sheet from the viewpoints of easiness of preparing a sheet excellent in workability.

(Thickness of Phosphor-Containing Resin Sheet)

The thickness of the phosphor-containing resin sheet is preferably 200 $\mu$m or less, more preferably 100 $\mu$m or less, and moreover preferably 50 $\mu$m or less from the viewpoints of improving heat resistance of the phosphor-containing resin sheet. In addition, in order to secure strength and handleability of the film on the basis that the phosphor-containing resin sheet contains the phosphor in an amount of 53% by weight or more, the sheet preferably have a thickness of 10 $\mu$m or more.

A thickness of the sheet in the present invention refers to a thickness (average thickness) measured according to JIS K 7130 (1999) "Plastics - Film and sheeting - Determination of thickness by mechanical scanning (A)".

The environment of the LED is an environment in which a large amount of heat is generated in a small space, and particularly in the case of a high power LED, heat generation is remarkable. A temperature of the phosphor is raised by such the heat generation and hence the luminance of the LED is reduced. Therefore, it is important how to release the generated heat with good efficiency. In the present invention, a sheet having excellent heat resistance can be attained by setting a thickness of the phosphor-containing resin sheet to the above-mentioned range. Further, when the thickness of the phosphor-containing resin sheet varies, there are differences in the amount of the phosphor among the LED chips, and consequently there are variations in emission spectrum. Accordingly, variations in the thickness of the phosphor-containing resin sheet are preferably within a range of plus or minus 5%, and more preferably within a range of plus or minus 3%.

In addition, the variations in the thickness referred to herein is determined by measuring a thickness according to JIS K 7130 (1999) "Plastics - Film and sheeting - Determination of thickness by mechanical scanning (A) ", and calculating from the following equation.

More specifically, using measurement conditions of "Determination of thickness by mechanical scanning (A)", a thickness is measured with a commercially available micrometer such as a contact type thickness measurement apparatus, a difference between a maximum value or a minimum value and an average thickness of the resulting thickness is calculated, and a ratio expressed in percentage of the calculated value divided by the average thickness is a thickness variation B (%).

$$\text{Thickness variation B (\%) = (maximum thickness deviation*}$$

$$\text{- average thickness)/average thickness} \times 100$$

As a maximum thickness deviation, of the two differences in the thickness between the maximum value and the average value, and between the minimum value and the average value, a larger difference is selected.

(Other Materials Constituting Resin Sheet Laminate)

A material of a release agent 6 is not particularly limited, and a material commonly used can be used. While a general-purpose release agent includes wax, liquid paraffin, silicone-based release agents, and fluorine-based agents, as a release agent for a resin, silicone-based release agents or fluorine-based release agents are often used, and these release agents are suitably used also in the present invention. Particularly, silicone-based release agents are suitable because of high mold releasability. A material selection or an application amount to the base material of the release agent 6 is determined depending on required peeling strength. That is, by appropriately selecting a type and a quantity of the release agent, the phosphor-containing resin sheet is not peeled from the base material in machining the sheet into a desired configuration, and the phosphor-containing resin sheet can be peeled quickly from the base material in bonding the sheet to the LED chip. Since the peeling strength varies depending on the composition of the phosphor-containing resin sheet even when the same release agent is used in the same amount, it is desirable to adjust the peeling strength for every phosphor-containing sheet to be used in order to obtain a required releasing property.

A material of the adhesive layer 7 is not particularly limited, and examples thereof include common rubber-based, acryl-based, urethane-based, and silicone-based adhesive agents. Any adhesive agent may be used, but the silicone-based adhesive agent is useful as an adhesive agent suitable for heat resistance, an insulating property and transparency.

A thickness of the adhesive layer 7 is preferably 2 $\mu$m or more and 200 $\mu$m or less. When the thickness of the adhesive layer 7 is 2 $\mu$m or more irrespective to the type of the adhesive agent, high peeling strength can be achieved. When the thickness of the adhesive layer is 200 $\mu$m or less, the phosphor-containing resin sheet can be machined without causing a failure in tackiness of the adhesive layer 7 in machining the phosphor-containing resin sheet into a desired configuration, and an optical loss is not produced after bonding the phosphor-containing resin sheet to the LED chip. Further, when it is necessary to embed a structure of the surface of the LED chip or a protruding object such as a mounted electrode, since these structures usually has a size of 100 $\mu$m or less, the adhesive layer 7 can achieve the adequate ability to embed these structures at a thickness of 200 $\mu$m or less.

The protective film may be disposed on the phosphor-containing resin sheet 2. A material of the protective film is not particularly limited, and examples thereof include polyethylene terephthalate (PET), polyethylene, polypropylene, polyvinyl chloride, and cellophane. Further, the protective film may be subjected to releasing treatment by a known release agent such as a silicone-based release agent or a fluorine-based release agent. The protective film can be disposed on the adhesive layer 7 when the adhesive layer 7 is present on the phosphor-containing resin sheet 2 as shown in Fig. 4.

(Preparation Method of Resin Sheet Laminate)

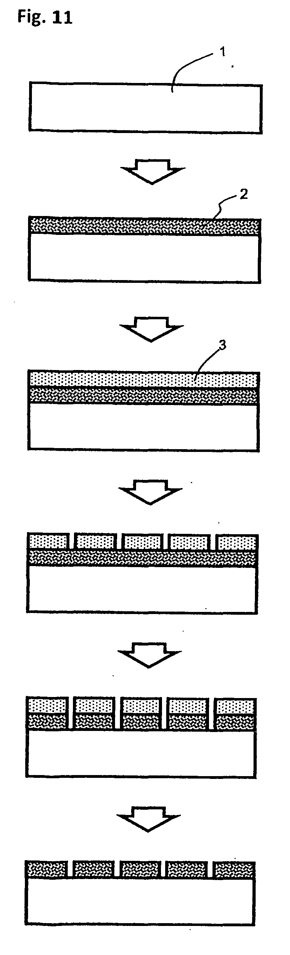

A method for manufacturing a resin sheet laminate of the present invention will be described by using Fig. 11 to Fig. 13. In addition, these are examples, the method for manufacturing a resin sheet laminate of the present invention is not limited to these examples.

Fig. 11 is a view showing an example of the method for manufacturing a resin sheet laminate of the present invention. The phosphor-containing resin sheet 2 is laminated on the base material 1 by a method described later. Then, a photoresist 3 is laminated and patterned to form a corrosion-resistant pattern, and the phosphor-containing resin sheet is etched with a chemical solution in which the phosphor-containing resin sheet can be dissolved by using the corrosion-resistant pattern as a mask to divide the phosphor-containing resin sheet 2 into a desired configuration. A commercialized product can be utilized as the photoresist.

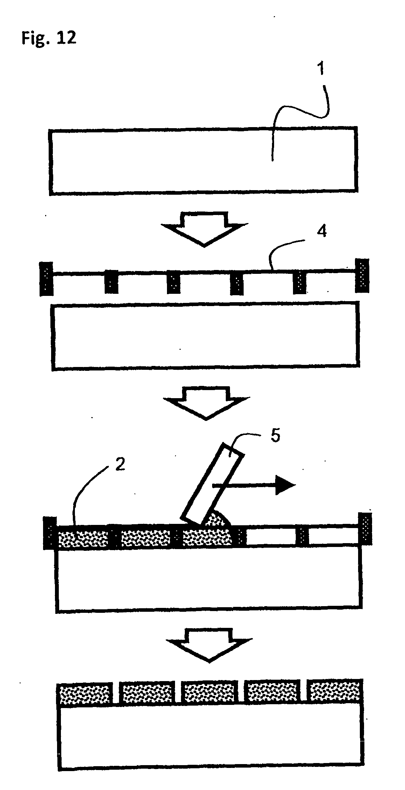

Fig. 12 is a view showing an example of another method for manufacturing a resin sheet laminate of the present invention. A screen printing plate 4 provided with a pattern formed is overlaid on a base material 1, and a paste formed by dispersing a phosphor in a resin solution is filled into the screen printing plate 4 with a squeegee 5, printed and dried to form a phosphor-containing resin sheet 2 divided into a predetermined configuration. In this method, since a method capable of printing in the form of a pattern such as screen printing is used in order to form a phosphor-containing resin layer on the base material, a phosphor-containing resin sheet desirably patterned can be directly obtained. As the screen printing plate, it is necessary to select a printing plate which is resistant to a solvent contained in the phosphor-containing resin. A stainless steel gauze provided with a pattern of a resin with high chemical resistance is preferred.

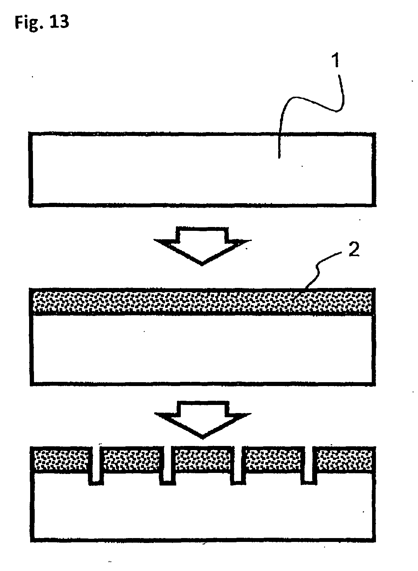

Fig. 13 is a view showing an example of still another method for manufacturing a resin sheet laminate of the present invention. The phosphor-containing resin sheet 2 is formed on the base material 1 by a method described later. Thereafter, the phosphor-containing resin sheet 2 is divided and machined into a desired configuration by any machining method of punching by a die, machining by a laser beam and cutting by a blade. When the phosphor-containing resin sheet is divided into each section, it is important that at least a part of the base material is not penetrated so that the base material is in a monolithic state, and cutting by a blade is desirable as a method of not penetrating base material. A cutting method by a blade includes a method of pushing a simple blade (straight blade) in the phosphor-containing resin sheet to cut it, and a method of cutting with a rotary blade. As an apparatus for cutting by the rotary blade, an apparatus referred to as a dicer, which is used for cutting (dicing) a semiconductor substrate into a separate chip, can be suitably utilized. When the dicer is used, a width of a dividing line can be precisely controlled by a thickness of the rotary blade or a setting of conditions, and therefore higher machining accuracy can be attained than cutting through pushing by a simple blade.

In any method of using a blade, it is possible to avoid cutting the base material while dividing the phosphor-containing resin sheet if a highly precise position control of the blade is performed. However, in actuality, it is very difficult to make a cut with exactly the same depth always. Therefore, in order to prevent the phosphor-containing resin sheet from being not properly divided when a cutting depth (cut depth) is slightly deviated, the cutting depth is preferably set at a depth with which the base material is partially cut. Accordingly, when the resin sheet laminate of the present invention is manufactured by the method shown in Fig. 13, virtually in most case, a concave portion not penetrating the base material is carved at the identical position of the base material as a position of cutting of the phosphor-containing resin sheet. "The identical position" referred to herein is identical in meaning to "the same position" described above. In this case, the concave portion is often formed in the form of a continuous groove or an intermittent groove, but the concave portion may become a break partially penetrating the base material as long as the base material is not split.

The resin sheet laminate of the present invention can also be suitably manufactured by the above-mentioned any method. However, a particularly suitable method is the method shown in Fig. 13. In the method shown in Fig. 13, since there is not a possibility of sheet damage due to the contact of the phosphor-containing resin sheet 2 with resist, chemicals or printing plate material, it is easy to obtain a uniform phosphor-containing resin sheet.

The method for preparing a resin sheet laminate of the present invention will be described in more detail. In addition, the following description is just an example, and the method for preparing a resin sheet laminate is not limited to this.

First, a solution in which a phosphor is dispersed in a resin (hereinafter, referred to as a "sheet solution") is prepared as a coating solution for forming a phosphor-containing resin sheet. The sheet solution can be prepared by mixing a phosphor and a resin in an appropriate solvent. In the case of using an addition cure silicone resin, since a curing reaction can be initiated at room temperature if a compound containing an alkenyl group coupled with a silicon atom is mixed with a compound containing a hydrogen atom coupled with a silicon atom, a delaying agent for a hydrosilylation reaction such as an acetylene compound can also be further mixed in the sheet solution to extend a pot life. It is also possible to mix a dispersant or a leveling agent for stabilizing a coated film as an additive, or an adhesion aid such as a silane coupling agent as a modifier of a sheet surface in the sheet solution. Also, inorganic particles such as silicone particles can be mixed in the sheet solution as an anti-settling agent for a phosphor.

The solvent is not particularly limited as long as it can adjust the viscosity of a fluent resin. Examples of the solvent include toluene, methyl ethyl ketone, methyl isobutyl ketone, hexane, acetone, and the like.

These components are blended so as to have predetermined composition, and then the resultant is uniformly mixed/dispersed with a mixer/kneader such as a homogenizer, a rotation-revolution mixer, a three roll mill, a ball mill, a planetary ball mill or a bead mill to obtain a sheet solution. After mixing/dispersing, or in the process of mixing/dispersing, deaeration is also preferably performed in a vacuum or under a reduced pressure.

Next, a sheet solution is applied onto a base material, and dried. Application can be performed by using a reverse roll coater, a blade coater, a slit die coater, a direct gravure coater, an offset gravure coater, a reverse roll coater, a blade coater, a kiss coater, screen printing, a natural roll coater, an air knife coater, a roll blade coater, a baribar roll blade coater, a two stream coater, a rod coater, a wire bar coater, a coating applicator, a dip coater, a curtain coater, a spin coater, a knife coater or the like. In order to achieve uniformity of the thickness of the sheet, the sheet solution is preferably applied with a slit die coater. Further, the phosphor-containing resin sheet of the present invention can also be prepared by using a printing method such as screen printing, gravure printing, planographic printing or the like. Particularly, screen printing is preferably used.

A sheet can be dried by using a common heating apparatus such as a hot air drier, an infrared drier or the like. A common heating apparatus such as a hot air drier, an infrared drier or the like is used for thermally curing the sheet. In this case, thermally curing is usually performed under the conditions of a temperature 40 to 250°C and a heating time 1 minute to 5 hours, and preferably under the conditions of a temperature 100°C to 200°C and a heating time 2 minutes to 3 hours.

Subsequently, as described above, the phosphor-containing resin sheet 2 formed on the base material can be divided into a predetermined configuration and section by the above method shown in Fig. 11 to Fig. 13.

When it is desired to obtain a divided configuration of the phosphor-containing resin sheet other than a simple rectangle, as shown in Fig. 6 and Fig. 8 to Fig. 10, a photomask or screen plate with a desired pattern only has to be prepared in the method shown in Fig. 11 and Fig. 12. In the case of the method shown in Fig. 13, the phosphor resin sheet needs to be machined by laser beam machining or the like before or after dividing the phosphor resin sheet into separate sections. Further, when as shown in Fig. 7, a resin sheet laminate machined so as to have a configuration of a hole partially penetrating the base material is obtained, the phosphor-containing resin sheet can be machined by punching by a die before or after dividing the phosphor-containing resin sheet into separate sections in any of the cases of Fig. 11 to Fig. 13.

(Bonding of Phosphor-Containing Resin Sheet to LED Chip)

By using Fig. 14 to Fig. 17, a step of bonding a phosphor-containing resin sheet to an LED chip by use of the resin sheet laminate of the present invention will be described. All of the cases of Fig. 14 to Fig. 17 are described, taking, as an example, a resin sheet laminate having a constitution shown in Fig. 2, that is, a constitution in which the resin sheet laminate does not have a release agent and an adhesive layer on either of the surface or the back side of the phosphor-containing resin sheet, and a dividing line not penetrating the base material is provided in the base material. In addition, also in the cases of using a resin sheet laminates having constitutions shown in Fig. 1, Fig. 3 and Fig. 4, the phosphor-containing resin sheet can be bonded to the LED chip by a similar step. Further, through in Fig. 14 to Fig. 17, the existence of a portion partially eliminated or a through hole in the phosphor-containing resin sheet is not particularly illustrated, a phosphor-containing resin sheet partially eliminated is illustrated in Fig. 6 and Fig. 7, and also in the case where an LED chip with a phosphor-containing resin sheet, in which a part of the LED chip is not covered with the phosphor-containing resin sheet, is manufactured by use of the phosphor-containing resin sheet partially eliminated, the phosphor-containing resin sheet can be bonded to the LED chip by a similar step.

Fig. 14 is a view showing an example of a method for manufacturing an LED chip provided with a phosphor-containing resin sheet on the emission surface thereof, and this method is a method in which the LED chip 9 previously divided into a singulated piece is bonded to the phosphor-containing resin sheet 2 divided on the base material 1 in resin sheet laminate 11 of the present invention.

First, the LED chip 9 is cut out of a wafer and divided into a singulated piece. An emission surface of the singulated piece is bonded to a divided section of the phosphor-containing resin sheet 2 by using a chip mounter or the like. The LED chip formed into a singulated piece is transported to a predetermined position on the phosphor-containing resin sheet 2 by, for example, a pick-up tool installed in the chip mounter, and the LED chip is pressed against a divided section of the phosphor-containing resin sheet 2 on the base material, and bonded by press-bonding. In this case, a press-bonded area may be heated as required. Thereafter, the phosphor-containing resin sheet bonded to the emission surface of the LED chip is peeled from the base material. Thus, an LED chip provided with a phosphor-containing resin sheet on the surface can be obtained.

When a method, in which the LED chip is bonded to the phosphor-containing resin sheet 2 on the base material in advance, and then the phosphor-containing resin sheet 2 is peeled from the base material 1 like the method shown in Fig. 14, is employed, the phosphor-containing resin sheet 2 is always supported by at least one of the base material 1 and the LED chip 9. Hence, there is not a possibility that the phosphor-containing resin sheet is damaged during a process even when the strength of the phosphor-containing resin sheet 2 is decreased by increasing a phosphor content in the phosphor-containing resin sheet, and therefore the phosphor-containing resin sheet can be bonded to the LED chip 9 at high yield. In the case of this method, while singulated pieces of the LED chip cut out of a wafer needs to be handled one by one, singulated pieces of the LED chip cut out of a wafer is outstandingly easy to handle since the singulated pieces have relatively high strength and stiffness, and is not deformed compared with the case where the phosphor-containing resin sheet is flexible and relatively low in strength, and is difficult to handle in the form of a singulated piece.

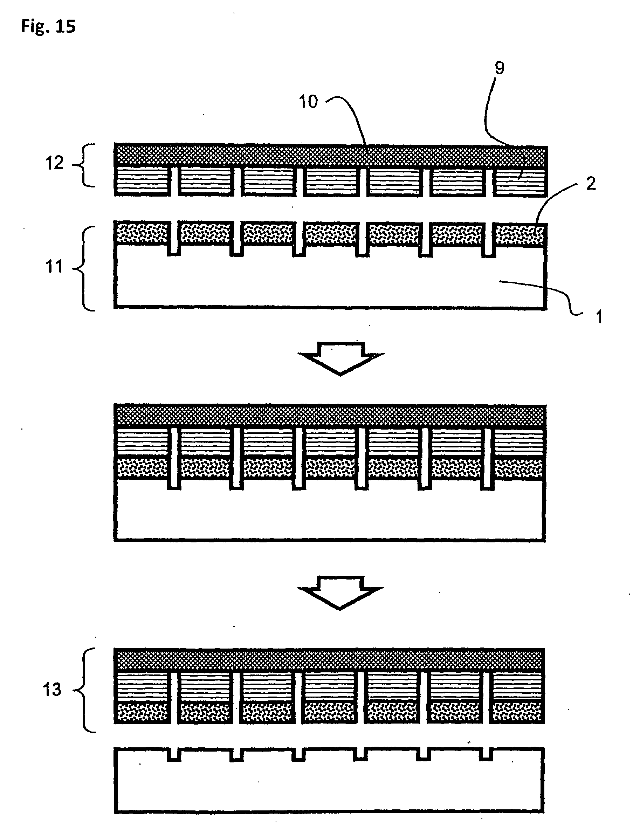

Fig. 15 is a view showing another example of a method for manufacturing an LED chip provided with a phosphor-containing resin sheet on the emission surface thereof, and an example of a method in which the divided phosphor-containing resin sheet is collectively bonded to a plurality of LED chips arranged so as to correspond to arrangement of the divided phosphor-containing resin sheet. In this example, a plurality of LED chips 9 are arranged at a desired pitch on a temporary fixing sheet 10 which is continuous in-plane direction for ease of handling with its emission surface faced upward to prepare an LED chip array 12 arranged on the temporary fixing sheet 10. Then, the arrangement of the LED chips 9 on the temporary fixing sheet is aligned with the arrangement of the sections of the phosphor-containing resin sheet 2 on the base material 1, and the LED chips 9 are collectively bonded to the sections of the phosphor-containing resin sheet 2. Thereafter, the phosphor-containing resin sheet 2 bonded to the emission surface of the LED chip 9 is peeled from the base material 1. Thus, an LED chip array 13 with a phosphor provided with a phosphor-containing resin sheet on the surface can be obtained.

In the method shown in Fig. 15, it is possible to bond the phosphor-containing resin sheet collectively to a plurality of LED chips. Further, by using the temporary fixing sheet 10, the LED chips can be arrayed at an arbitrary pitch. That is, LED chips arrayed on a mounting substrate do not necessarily have a dense array pitch, and there may be cases where a distance between the LED chips is large. In this case, when the phosphor-containing resin sheet is divided and machined with its arrangement aligned with the arrangement of the LED chips having a large distance in order to bond the phosphor-containing resin sheet collectively to the LED chips having a large distance, since a distance between the phosphor-containing resin sheet 2 on the resin sheet laminate 11 becomes large to increase an area to be not used, usage efficiency may be deteriorated. On the other hand, in the method shown in Fig. 15, it becomes possible to bond the phosphor-containing sheet collectively by making an array of the LED chips on the temporary fixing sheet dense without decreasing the usage efficiency of the phosphor-containing resin sheet.

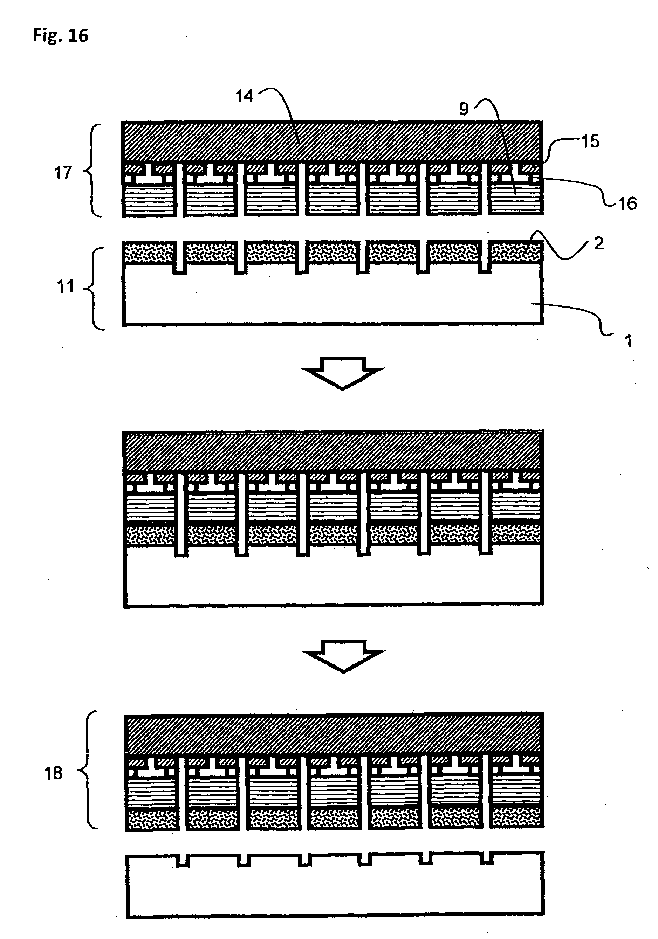

Fig. 16 to Fig. 17 are applications of the method of Fig. 15, and an example of the case of using a substrate, on which a plurality of LED chips arranged so as to correspond to the arrangement of the divided phosphor-containing resin sheet are mounted.

Fig. 16 is a view showing another example of a method for manufacturing an LED chip provided with a phosphor-containing resin sheet on the emission surface thereof, and this method is a method of bonding the phosphor-containing resin sheet 2 collectively to LED chips 9 mounted on the surface of the base material. In this method, a substrate 17 having an LED chip mounted thereon, in which a plurality of LED chips 9 provided with a bump 16 are mounted on the surface of a mounting substrate 14 with a pad electrode 15 of the mounting substrate 14 interposed therebetween, is collectively bonded to the phosphor-containing resin sheet 2 on the base material 1. Thereafter, the phosphor-containing resin sheet bonded to the emission surface of the LED chip is peeled from the base material 1. Thus, a substrate 18 having an LED chip mounted thereon, provided with a phosphor-containing resin sheet on the surface, can be obtained.

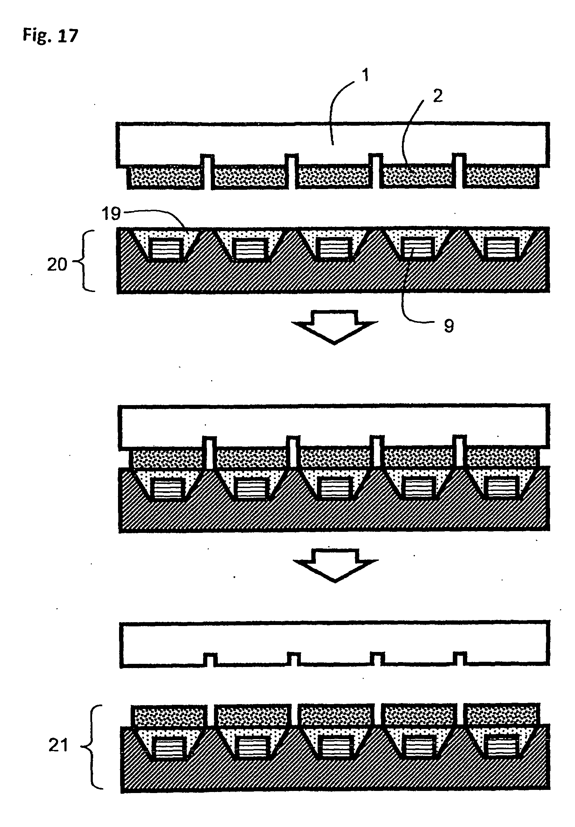

Fig. 17 is a view showing another example of a method for manufacturing an LED chip provided with a phosphor-containing resin sheet on the emission surface thereof, and this method is a method of bonding a plurality of LED chips 9 mounted on a substrate and sealed with a resin collectively to the phosphor-containing resin sheet 2. Specifically, a mounting substrate 20 in which LED chips 9 are mounted in a concave portion of the mounting substrate and embedded in a sealing resin 19 is collectively bonded to the phosphor-containing resin sheet 2 on the base material 1. Thereafter, the phosphor-containing resin sheet bonded to the emission surface of the LED chip is peeled from the base material 1. Thus, a substrate 21 having an LED chip mounted thereon, provided with a phosphor-containing resin sheet on the surface, can be obtained.

In addition, in Fig. 17, a substance with which the bonded phosphor-containing resin sheet 2 is in contact is a sealing resin 19, but since a face on the sealing resin 19 side in the mounting substrate 20 is an emission surface of the LED chip, in the present specification, an embodiment shown in Fig. 17 is included in an aspect of bonding the resin sheet laminate to the emission surface of the LED chip.

In the case of the method shown in Fig. 16 to Fig. 17, since the temporary fixing sheet is not required and the phosphor-containing resin sheet can be bonded directly to an LED chip mounted on the substrate, a process can be further shortened.

DESCRIPTION OF REFERENCE SIGNS

| | |
|---|---|
| 1 | base material |
| 2 | phosphor-containing resin sheet |
| 3 | photoresist |
| 4 | screen printing plate |
| 5 | squeegee |
| 6 | release agent |
| 7 | adhesive layer |
| 8 | through hole |
| 9 | LED chip |
| 10 | temporary fixing sheet |
| 11 | resin sheet laminate |
| 12 | LED chip array arranged on a temporary fixing sheet |
| 13 | LED chip array with a phosphor |
| 14 | mounting substrate |
| 15 | pad electrode |
| 16 | bump |

(continued)

| 17 | substrate having LED chip mounted thereon |
| 18 | substrate having LED chip mounted thereon in which phosphor-containing resin sheet is disposed on surface |
| 19 | sealing resin |
| 20 | mounting substrate |
| 21 | substrate having LED chip mounted thereon in which a phosphor-containing resin sheet is disposed on surface |

**Claims**

1. A resin sheet laminate provided with a phosphor-containing resin sheet on a base material, wherein said phosphor-containing resin sheet is divided into a plurality of sections.

2. The resin sheet laminate according to claim 1, wherein said base material is continuous in-plane direction throughout said plurality of sections of said phosphor-containing resin sheet.

3. The resin sheet laminate according to claim 1 or 2, wherein said base material has a concave portion at the same position as the position of a boundary dividing a phosphor-containing resin sheet.

4. The resin sheet laminate according to any one of claims 1 to 3, wherein a release agent is present between said base material and said phosphor-containing resin sheet.

5. The resin sheet laminate according to any one of claims 1 to 3, wherein an adhesive layer is laminated on said phosphor-containing resin sheet.

6. The resin sheet laminate according to any one of claims 1 to 5, wherein said base material having said phosphor-containing resin sheet laminated thereon is a resin film.

7. The resin sheet laminate according to any one of claims 1 to 6, wherein in said sections in said phosphor-containing resin sheet, its configuration at the time when viewed from a direction perpendicular to in-plane direction of the sheet is a regularly repeated pattern.

8. The resin sheet laminate according to any one of claims 1 to 7, wherein said phosphor-containing resin sheet is bonded to an emission surface of an LED.

9. A method for manufacturing the resin sheet laminate according to any one of claims 1 to 8, which forms a phosphor-containing resin sheet divided into a plurality of sections on a base material to manufacture a resin sheet laminate, wherein a step of dividing the phosphor-containing resin sheet into a plurality of sections is performed by at least one method among etching by chemicals, patterning by screen printing, punching by a die, machining by a laser beam and cutting by a blade.

10. A method for manufacturing an LED chip with a phosphor-containing resin sheet, comprising the steps of: (A) bonding an emission surface of the LED chip to the divided phosphor-containing resin sheet in the resin sheet laminate according to any one of claims 1 to 8, and (B) peeling the phosphor-containing resin sheet bonded to the emission surface of the LED chip from the base material.

11. The method for manufacturing an LED chip with a phosphor-containing resin sheet according to claim 10, wherein in said step (A), the emission surfaces of a plurality of LED chips arranged so as to correspond to an arrangement of said plurality of sections of said phosphor-containing resin sheet are collectively bonded to said phosphor-containing resin sheet.

Fig. 1

Fig. 2

Fig. 3

Fig. 4

**Fig. 5**

**Fig. 6**

Fig. 7

Fig. 8

Fig. 9

Fig. 10

**Fig. 11**

**Fig. 12**

**Fig. 13**

Fig. 14

**Fig. 15**

Fig. 16

Fig. 17

<div align="center">

**INTERNATIONAL SEARCH REPORT**

</div>

| | International application No. |
|---|---|
| | PCT/JP2012/060912 |

**A. CLASSIFICATION OF SUBJECT MATTER**
*B32B27/00*(2006.01)i, *B32B3/14*(2006.01)i, *H01L33/50*(2010.01)i

According to International Patent Classification (IPC) or to both national classification and IPC

**B. FIELDS SEARCHED**

Minimum documentation searched (classification system followed by classification symbols)
B32B1/00-43/00, H01L33/50

Documentation searched other than minimum documentation to the extent that such documents are included in the fields searched

| Jitsuyo Shinan Koho | 1922-1996 | Jitsuyo Shinan Toroku Koho | 1996-2012 |
|---|---|---|---|
| Kokai Jitsuyo Shinan Koho | 1971-2012 | Toroku Jitsuyo Shinan Koho | 1994-2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2011-102004 A (Nitto Denko Corp.), 26 May 2011 (26.05.2011), entire text (Family: none) | 1-11 |
| A | JP 2010-258281 A (Nichia Chemical Industries, Ltd.), 11 November 2010 (11.11.2010), entire text (Family: none) | 1-11 |
| A | JP 2009-239022 A (Lintec Corp.), 15 October 2009 (15.10.2009), entire text (Family: none) | 1-11 |

| ☒ Further documents are listed in the continuation of Box C. | ☐ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 July, 2012 (10.07.12) | 24 July, 2012 (24.07.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2012/060912

C (Continuation). DOCUMENTS CONSIDERED TO BE RELEVANT

| Category* | Citation of document, with indication, where appropriate, of the relevant passages | Relevant to claim No. |
|---|---|---|
| A | JP 2000-156528 A (Sharp Corp.), 06 June 2000 (06.06.2000), entire text (Family: none) | 1-11 |
| P,A | JP 2011-228602 A (Toray Industries, Inc.), 10 November 2011 (10.11.2011), entire text (Family: none) | 1-11 |
| E,A | WO 2012/081411 A1 (Toray Industries, Inc.), 21 June 2012 (21.06.2012), entire text (Family: none) | 1-11 |
| E,A | JP 2012-99664 A (Shin-Etsu Chemical Co., Ltd.), 24 May 2012 (24.05.2012), entire text (Family: none) | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5152609 A
- JP 7099345 A
- JP 4146406 B

- JP 2000156528 A
- JP 2010159411 A

**Non-patent literature cited in the description**

- Plastics - Film and sheeting - Determination of thickness by mechanical scanning (A. *JIS K 7130,* 1999